# EUROPEAN PATENT SPECIFICATION

(11) **EP 2 672 795 B1**
(45) Date of publication and mention of the grant of the patent: **25.07.2018**
(21) Application number: 13169561.1
(22) Date of filing: 28.05.2013
(51) Int. Cl.: H05K 7/14

(54) **MOVABLE LUGS AND ASSISTANCE DEVICE FOR REMOVING EQUIPMENT FROM RACK**
BEWEGLICHE KABELSCHUHE UND HILFSVORRICHTUNG ZUM ENTFERNEN EINES GERÄTS AUS EINEM GESTELL
DISPOSITIF D'ASSISTANCE ET DE LANGUETTES MOBILES POUR L'ÉLIMINATION DE MATÉRIEL À CRÉMAILLÈRE

(30) Priority: 07.06.2012 TW 101120412
(43) Date of publication of application: 11.12.2013
(73) Proprietor: Tseng, Ching-Chao, Changhua County 509 (TW)
(72) Inventor: Chen, Ching-Sheng, 270 Yilan County (TW)
(74) Representative: Lang, Christian

(56) References cited:
- US-A- 5 277 615
- US-A1- 2005 284 033

## Description

### BACKGROUND OF THE INVENTION

### (1) FIELD OF THE INVENTION

The present invention relates to a movable lug and an assistance device cooperated with the movable lug, and more particularly, to the movable lug and the assistance device which allows the equipment to be removed from the rack from the rear end of the rack.

### (2) DESCRIPTION OF THE PRIOR ART

Along with the requirements of more users using the internet information in the same time, a lot of routers are needed to manage the transmission of the signals. Therefore, there can be multiple routers installed in one rack.

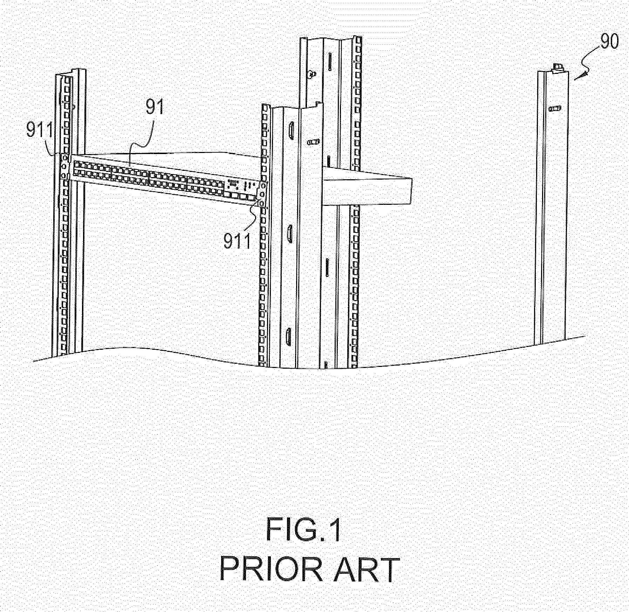

These equipments such as the routers are installed in the rack and the cables are then connected to the equipments so as to save space and easily manage the cables and the routers. As shown in Fig. 1, the conventional way to set the equipment 91 is to set two lugs 911 which are fixed to the rack 90 by bolts such that the equipment 91 is positioned in the rack. Because the lugs 911 have to be cooperated with the locking holes of the rack 90, so that the equipment 91 can only be inserted into the front side of the rack 90 by its rear end. In other words, when the equipment 91 is to be removed from the rack 90, the equipment 91 has to be removed from the front side of the rack 90. However, there are cables of other equipments located at the removal path of the equipment 91 so that the removable action is interfered by the cables.

US 2005/0284033 A1 discloses an electronic apparatus with an integrated rotatable element. The rotatable element can be pivoted with respect to the housing of the electronic apparatus, which can be mounted on a rack by means of the rotatable element and screws.

US 5,277,615 A discloses a support tray allowing for a disk drive to be arranged in a cage structure. The support tray comprises on its front side a pair of pivotable latch members with a hook portion which engages with the cage structure when the support tray is arranged in it.

The present invention intends to provide a movable lugs which allow the equipment to be removed from the rear end of the rack.

### SUMMARY OF THE INVENTION

The present invention relates to an assistance device with the features of claim 1. Further embodiments are subject-matter of the dependent claims. The assistance device comprises a first movable lug comprises a first hinge having a first left plate and a first right plate. The first left plate is fixed to the equipment and the first right plate is fixed to the assistance device. The first right plate is pivotably connected to the first left plate. Further, the assistance device comprises a second movable lug having a second hinge with a second left plate and a second right plate. The second left plate is fixed to the assistance device. The second right plate is fixed to the equipment. The second right plate is pivotably connected to the second left plate.

When the equipment is to be removed from the rack, the bolts extending through the first right plate and the second left plate are removed, and the first right plate and the second left plate are moved inward so as to pass through the rack and move backward. Therefore, the equipment is not interfered by cables of other equipments.

The first left plate has an elongate hole and the first right plate has multiple locking holes. The second left plate has multiple locking holes and the second right plate has an elongate hole. The locking holes are cooperated with the holes of the assistance device, these plates are secured.

The first left plate is connected to a first top plate and a first bottom plate. The first top plate has a locking hole and an elongate hole. The first bottom plate has a locking hole and an elongate hole. The second right plate is connected to a second top plate and a second bottom plate. The second top plate has a locking hole and an elongate hole. The second bottom plate has a locking hole and an elongate hole. The first and second hinges can be cooperated with the equipment that has different distances between holes.

The assistance device is connected to the movable lugs. The assistance device comprises a first rail, a second rail, a tray, a first locking plate and a second locking plate. The first rail is fixed to the rack and the second rail is located corresponding to the first rail and fixed to the rack. The tray has a first slide and a second slide, wherein the first slide is engaged with the first rail and the second slide is engaged with the second rail. The first locking plate protrudes from one end of the first rail and is connected with a first right plate of the first movable lug. The second locking plate protrudes from one end of the second rail and is connected with a second left plate of the second movable lug.

The assistance device is cooperated with the movable lugs and supports the equipment so that the equipment is not tilt because of the deformation of the movable lugs due to the weight of the equipment.

The assistance device is for replacing an equipment connected to a rack, the assistance device comprising a first hinge, a second hinge, a first rail, a second rail, and a tray. The first hinge having a first left plate which is adapted to be fixed to an equipment, a first right plate which is adapted to be fixed to a rack or the assistance device, the first right plate pivotably connected to the first left plate. The second hinge having a second left plate which is adapted to be fixed to the rack or the assistance device, a second right plate which is adapted to be fixed to the equipment, the second right plate pivotably connected to the second left plate. The first rail fixed to the rack, a first locking plate protruding from an end of the first rail and being connected with the first right plate. The second rail located corresponding to the first rail and fixed to the rack, a second locking plate protruding from an end of the second rail and connected with the second left plate. The tray having a first slide and a second slide, the first slide engaged with the first rail and the second slide engaged with the second rail.

The first left plate has an elongate hole and the first right plate has multiple locking holes. The second left plate has multiple locking holes and the second right plate has an elongate hole. By the cooperation between the slots and the locking holes, the connection is more easily.

Preferably, the first locking plate has a first connection portion which has a first slot. The second locking plate has a second connection portion which has a second slot. By the first and second slots, the connection between the first locking plate and the first rail, and the connection between the second locking plate and the second rail are more easily.

Preferably, the first rail is connected to a first positioning member and the second rail is connected to a second positioning member. The first positioning member is located corresponding to the first locking plate and has a first rail securing member and a first rack securing member. The first rail securing member is connected to the first rack securing member. The second positioning member is located corresponding to the second locking plate and has a second rail securing member and a second rack securing member. The second rail securing member is connected to the second rack securing member. By the first positioning member and the second positioning member, the first and second rails are more securely connected to the rack.

Preferably, the tray has at least one through hole so that the user can lift the equipment via the through hole, the through hole also assist the heat dissipation.

The present invention will become more obvious from the following description when taken in connection with the accompanying drawings which show, for purposes of illustration only, a preferred embodiment in accordance with the present invention.

### BRIEF DESCRIPTION OF THE DRAWINGS

Fig. 1 is a perspective view to show an equipment connected to a conventional rack;
Fig. 2 is a perspective view to show the movable lugs of the present invention connected to an equipment;
Fig. 3 shows the movable lugs and the assistance device of the present invention connected to an equipment;
Fig. 4 shows the movable lugs of the present invention connected to the rack;
Fig. 5 is an exploded view to show the movable lugs and the assistance device of the present invention;
Fig. 6 is an enlarged view to show the connection of the tray, the first slide, the first slide, the first top plate;
Fig. 7 shows that the equipment is connected to the rack by the movable lugs and the assistance device of the present invention, and
Figs. 8 and 9 show that the operation of the assistance device of the present invention.

### DETAILED DESCRIPTION OF THE PREFERRED EMBODIMENTS

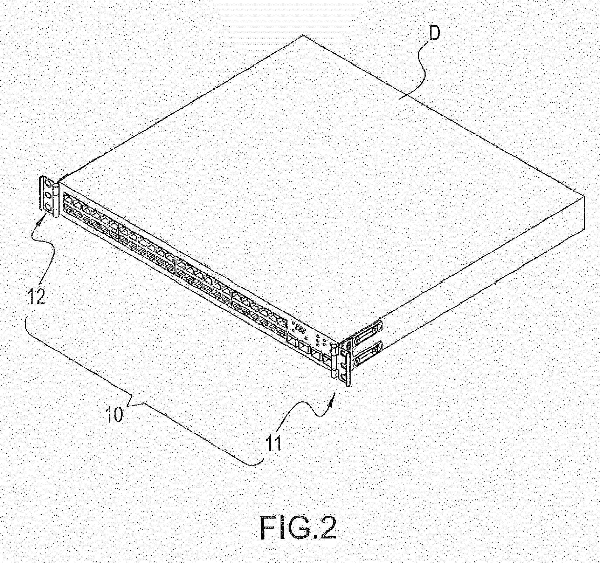

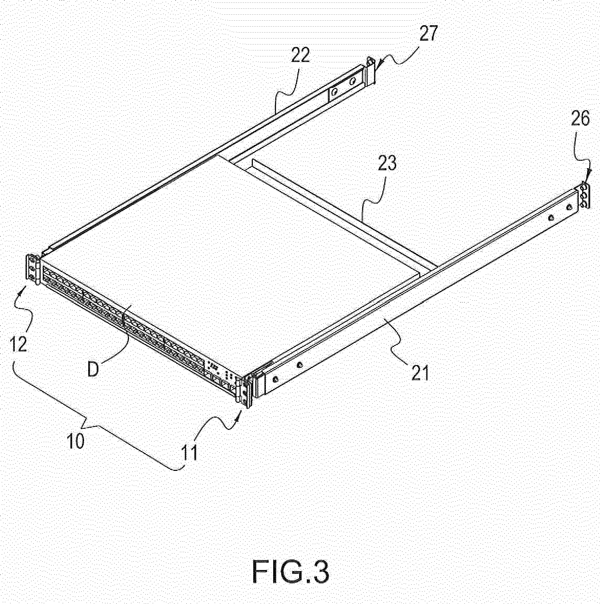

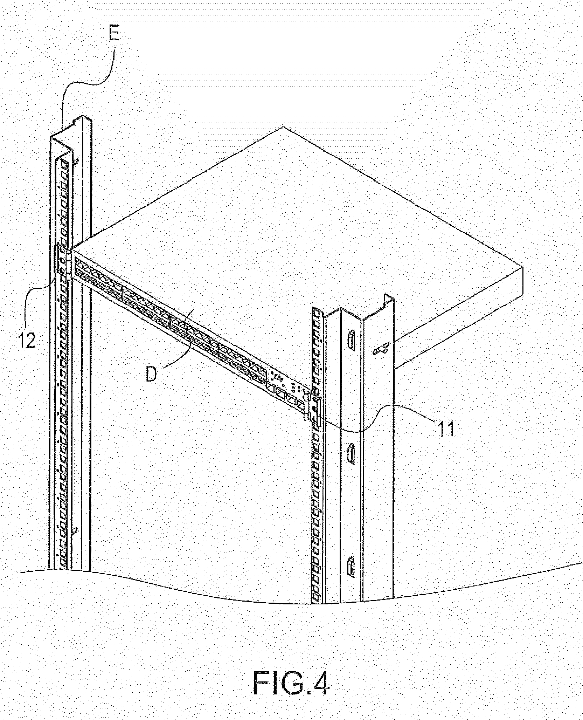

Referring to Figs. 2 to 5, the movable lug 10 of the present invention is used to connect an equipment D to a rack E or an assistance device F, wherein the movable lug 10 comprises a first hinge 11 and a second hinge 12.

The first hinge 11 has a first left plate 111 and a first right plate 112 which is pivotably connected to the first left plate 111. The first left plate 111 is fixed to the equipment D by at least one locking member. The first right plate 112 is fixed to the rack E or the assistance device F by at least one locking member. The second hinge 12 has a second left plate 121 and a second right plate 122 which is pivotably connected to the second left plate 121. The second left plate 121 is fixed to the rack E or the assistance device F by at least one locking member. The second right plate 122 is fixed to the equipment D by at least one locking member.

The first right plate 112 and the second left plate 121 are able to respectively rotated relative to the first left plate 111 and the second right plate 122, so that when removing the locking members of the first right plate 112 and the second left plate 121, the equipment D can be moved backward so that the cables on the front of the equipment D cannot interfere the movement of the equipment D.

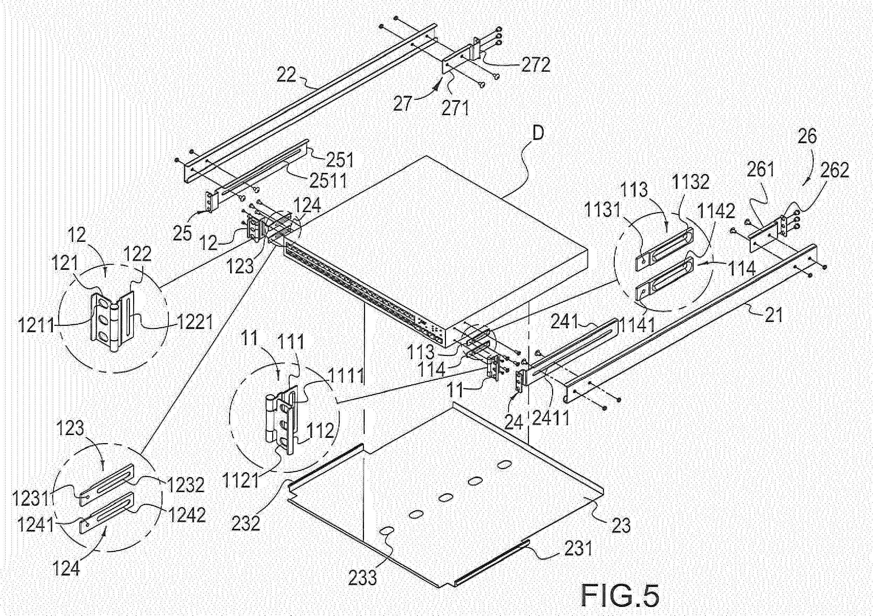

As shown in Fig. 5, the first left plate 111 has an elongate hole 1111 and the first right plate 112 has multiple locking holes 1121. The second left plate 121 has multiple locking holes 1211 and the second right plate 122 has an elongate hole 1221. By the elongate holes 1111 and 1221, the holes in the equipment D are easily connected to the first left plate 111 and the second right plate 122 without wasting time for aligning the holes. These locking holes 1121 and 1211 are used to be connected with the rack E or the assistance device F.

The first left plate 111 is connected to a first top plate 113 and a first bottom plate 114. The first top plate 113 has a locking hole 1131 and an elongate hole 1132. The first bottom plate 114 has a locking hole 1141 and an elongate hole 1142. The second right plate 122 is connected to a second top plate 123 and a second bottom plate 124. The second top plate 123 has a locking hole 1231 and an elongate hole 1232. The second bottom plate 124 has a locking hole 1241 and an elongate hole 1242. The equipment D is connected to the first left plate 111 and the second right plate 122 easily without customized first and second hinges.

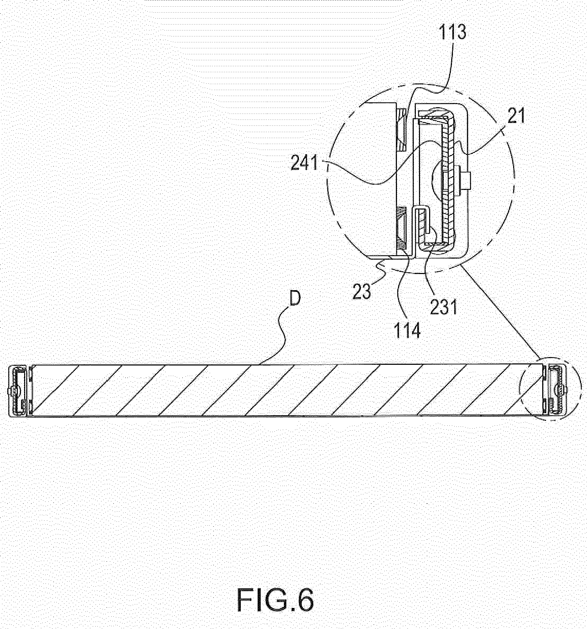

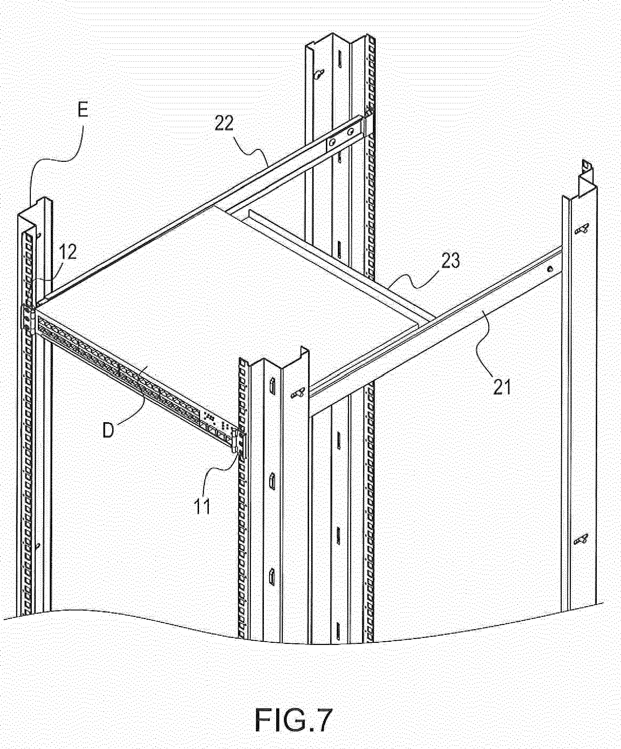

As shown in Figs. 5 to 9, the present invention further provides the assistance device F which is connected with the movable lugs 10, and then connected to the rack E. The assistance device F comprises a first rail 21, a second rail 22, a tray 23, a first locking plate 24 and a second locking plate 25. The tray 23 supports the equipment D and both are moved backward when the movable lugs 10 are separated from the rack E by removing the locking members.

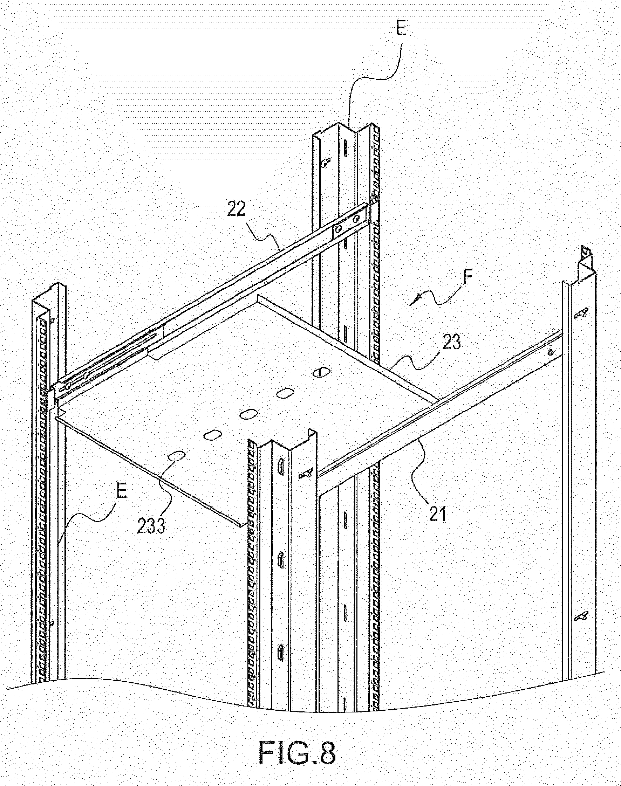

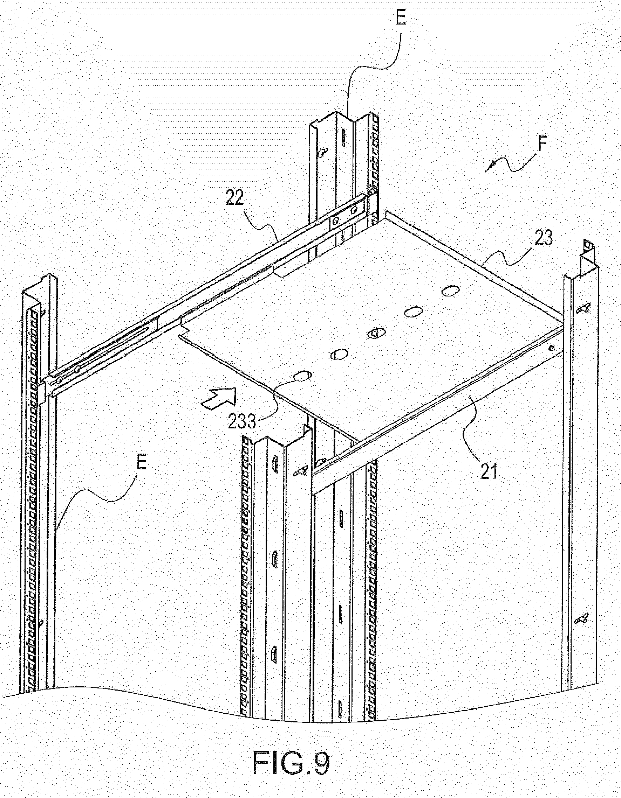

The first rail 21 and the second rail 22 are connected to the rack E, and the second rail 22 is located corresponding to the first rail 21. The tray 23 has a first slide 231 and a second slide 232, wherein the first slide 231 is engaged with the first rail 21 and the second slide 232 is engaged with the second rail 22, so that the tray 23 is moved back and forth as shown in Figs. 8 and 9. The first locking plate 24 protrudes from one end of the first rail 21 and is connected with the first right plate 112 of the movable lug 10 by a locking member. The second locking plate 25 protrudes from one end of the second rail 22 and is connected with the second left plate 121 of the movable lug 10 by a locking member.

By the cooperation of the movable lugs 10 and the assistance device F, the equipment D can be moved back and forth to be installed to the rack or to be removed from the rack.

The first locking plate 24 has a first connection portion 241 which has a first slot 2411. The second locking plate 25 has a second connection portion 251 which has a second slot 2511. By the first and second slots 2411, 2511, the positions of the first and second locking plates 24, 25 relative to the first and second rails 21, 22, so that the first and second rails 21, 22 are able to be used for different racks E.

Furthermore, the first rail 21 is connected to a first positioning member 26 and the second rail 22 is connected to a second positioning member 27. The first positioning member 26 is located corresponding to the first locking plate 24. The first positioning member 26 has a first rail securing member 261 and a first rack securing member 262. The first rail securing member 261 is connected to the first rack securing member 262. The second positioning member 27 is located corresponding to the second locking plate 25. The second positioning member 27 has a second rail securing member 271 and a second rack securing member 272. The second rail securing member 271 is connected to the second rack securing member 272. By the first and second positioning members 26, 27, the rails are more securely connected to the rack E such that the tray 23 moves smoothly.

Besides, the tray 23 has at least one through hole 233 through which the user's fingers may extend and lift the equipment D, so that the equipment D is easily grabbed and the at least one through hole 233 also enhances the heat dissipating feature.

While we have shown and described the embodiment in accordance with the present invention, it should be clear to those skilled in the art that further embodiments may be made without departing from the scope of the present invention.

## Claims

1. An assistance device (F) for replacing an equipment (D) connected to a rack (E), which allows the equipment to be removed from the rack (E) from the rear end of the rack (E),
the assistance device (F) comprising
a first and second rail (21, 22) fixed to the rack (E), a tray (23) for supporting the equipment (D) that has slides (231, 232) engaging with said rails (21, 22), respectively, so that the tray (23) is movable back and forth;
a first locking plate (24) protruding from an end of the first rail (21) and being connected to a first movable lug;
a second locking plate (25) protruding from an end of the second rail (22) and connected to a second movable lug;
wherein the first movable lug comprises a first hinge (11) having a first left plate (111) and a first right plate (112) which is connectable to the first locking plate (24) by locking members and which is pivotably connected to the first left plate (111),
wherein the first left plate (111) has an elongate hole (1111) the longitudinal axis of which is oriented vertically in operation and the first right plate (112) has multiple locking holes (1121),
wherein the second movable lug comprises a second hinge (12) having a second left plate (121) which is connectable to the second locking plate (25) by locking members and a second right plate (122) which is pivotably connected to the second left plate (121),
wherein the second left plate (121) has multiple locking holes (1211) and the second right plate (122) has an elongate hole (1221) the longitudinal axis of which is oriented vertically in operation;
the first movable lug further comprising a first top plate (113) having a locking hole (1131) and an elongate hole (1132) and a first bottom plate (114) having a locking hole (1141) and an elongate hole (1142), wherein the longitudinal axis of the elongated holes (1132, 1142) is oriented horizontally in operation;
the second movable lug further comprising a second top plate (123) having a locking hole (1231) and an elongate hole (1232) and a second bottom plate (124) having a locking hole (1241) and an elongate hole (1242), wherein the longitudinal axis of the elongate holes (1232, 1242) is oriented horizontally in operation;
wherein the first left plate (111) is connected to the first top plate (113) and the first bottom plate (114),
wherein the second right plate (122) is connected to the second top plate (123) and the second bottom plate (124),
such that when the first right plate (112) and the second left plate (121) are respectively rotated relative to the first left plate (111) and the second right plate (122) and locking members connecting the first right plate (112) and the second left plate (121) to the first and second locking plate (24, 25) are removed, the equipment (D) can be moved backward so that the cables on the front of the equipment (D) cannot interfere the movement of the equipment (D).

2. The device as claimed in claim 1, wherein the first locking plate (24) has a first connection portion (241) which has a first slot (2411), the second locking plate (25) has a second connection portion (251) which has a second slot (2511).

3. The device as claimed in claim 1, wherein the first rail (21) is connected to a first positioning member (26) and the second rail (22) is connected to a second positioning member (27), the first positioning member (26) is located corresponding to the first locking plate (24) and has a first rail securing member (261) and a first rack securing member (262), the first rail securing member (261) is connected to the first rack securing member (262), the second positioning member (27) is located corresponding to the second locking plate (25) and has a second rail securing member (271) and a second rack securing member (272), the second rail securing member (271) is connected to the second rack securing member (272).

4. The device as claimed in claim 1, wherein the tray (23) has at least one through hole (233).

## Patentansprüche

1. Hilfsvorrichtung (F) zum Ersetzen einer Ausstattung (D), die mit einem Rack (E) verbunden ist, welche es der Ausstattung (D) erlaubt, von dem Rack (E) von dem hinteren Ende des Racks (E) entfernt zu werden,
wobei die Hilfsvorrichtung (F) umfasst:
eine erste und zweite Schiene (21, 22), die an dem Rack (E) befestigt sind,
eine Ablage (23) zum Lagern der Ausrüstung (D), die Gleitschienen (231, 232) hat, die jeweils in Eingriff stehen mit den genannten Schienen (21, 22), so dass die Ablage (23) vor und zurück bewegt werden kann,
eine erste Verriegelungsplatte (24), die aus einem Ende der ersten Schiene (21) hervorragt und verbunden ist mit einem ersten beweglichen Vorsprung, eine zweite Verriegelungsplatte (25), die aus einem Ende der zweiten Schiene (22) hervorragt und verbunden ist mit einem zweiten beweglichen Vorsprung,
wobei der erste bewegliche Vorsprung ein erstes Scharnier (11) umfasst,
das eine erste linke Platte (111) und eine erste rechte Platte (112) umfasst,
die durch Verriegelungselemente mit der ersten Verriegelungsplatte (24) verbunden werden kann und welche schwenkbar mit der ersten linken Platte (111) verbunden ist,
wobei die erste linke Platte (111) ein längliches Loch (1111) hat, dessen longitudinale Achse im Betrieb vertikal orientiert ist, und wobei die erste rechte Platte (112) mehrere Verriegelungslöcher (1121) aufweist,
wobei der zweite bewegliche Vorsprung ein zweites Scharnier (12) umfasst,
das eine zweite linke Platte (121) hat, die durch Verriegelungselemente mit der zweiten Verriegelungsplatte (25) verbunden werden kann und eine zweite rechte Platte (122), die schwenkbar mit der zweiten linken Platte (121) verbunden ist,
wobei die zweite linke Platte (121) mehrere Verriegelungslöcher (1211) hat und die zweite rechte Platte (122) ein längliches Loch (1221) aufweist, dessen longitudinale Achse im Betrieb vertikal orientiert ist,
wobei der erste bewegliche Vorsprung ferner eine erste obere Platte (113), die ein Verriegelungsloch (1131) und ein längliches Loch (1132) aufweist,
und eine erste untere Platte (114) umfasst, die ein Verriegelungsloch (1141) und ein längliches Loch (1142) aufweist, wobei die longitudinale Achse der länglichen Löcher (1132, 1142) im Betrieb horizontal orientiert ist,
wobei der zweite bewegliche Vorsprung ferner eine zweite obere Platte (123), die ein Verriegelungsloch (1231) und ein längliches Loch (1232) aufweist, und eine zweite untere Platte (124) umfasst, die ein Verriegelungsloch (1241) hat und ein längliches Loch (1142) aufweist, wobei die longitudinale Achse der länglichen Löcher (1232, 1242) im Betrieb horizontal orientiert ist,
wobei die erste linke Platte (111) mit der ersten oberen Platte (113) und der ersten unteren Platte (114) verbunden ist,
wobei die zweite rechte Platte (122) verbunden ist mit der zweiten oberen Platte (123) und der zweiten unteren Platte (124),
so dass, wenn die erste rechte Platte (112) und die zweite linke Platte (121) jeweils relativ zu der ersten linken Platte (111) und der zweiten rechten Platte (122) rotiert werden und Verriegelungselemente, die die erste rechte Platte (112) und die zweite linke Platte (121) mit der ersten und zweiten Verriegelungsplatte (24, 25) verbinden, entfernt werden, die Ausstattung (D) nach hinten bewegt werden kann, so dass die Kabel an der Vorderseite der Ausstattung (D) die Bewegung der Ausstattung (D) nicht beeinträchtigen kann.

2. Vorrichtung nach Anspruch 1, bei welchem die erste Verriegelungsplatte (24) einen ersten Verbindungsabschnitt (241) aufweist, der einen ersten Steckplatz (2411) hat, und wobei die zweite Verriegelungsplatte (25) einen zweiten Verbindungsabschnitt (251) aufweist, der einen zweiten Steckplatz (2511) hat.

3. Vorrichtung nach Anspruch 1, bei welchem die erste Schiene (21) mit einem ersten Positionierelement (26) verbunden ist und die zweite Schiene (22) mit einem zweiten Positionierelement (27) verbunden ist, wobei das erste Positionierelement (26) entsprechend der ersten Verriegelungsplatte (24) angeordnet ist und ein erstes Schienensicherungselement (261) und ein erstes Racksicherungselement (262) aufweist, wobei das erste Schienensicherungselement (261) mit dem ersten Racksicherungselement (262) verbunden ist, wobei das zweite Positionierelement (27) entsprechend der zweiten Verriegelungsplatte (25) angeordnet ist und ein zweites Schienensicherungselement (271) und ein zweites Racksicherungselement (272) aufweist, wobei das zweite Schienensicherungselement (271) mit dem zweiten Racksicherungselement (272) verbunden ist.

4. Vorrichtung nach Anspruch 1, bei welchem die Ablage (23) zumindest eine Durchgangsöffnung (233) aufweist.

## Revendications

1. Dispositif d'assistance (F) pour remplacer un équipement (D) raccordé à un râtelier (E), qui permet à l'équipement d'être retiré du râtelier (E) à partir de l'extrémité arrière du râtelier (E),
le dispositif d'assistance (F) comprenant
des premier et second rails (21, 22) fixés au râtelier (E), un plateau (23) pour supporter l'équipement (D) qui possède des coulisseaux (231, 232) entrant en prise avec lesdits rails (21, 22), respectivement, pour que le plateau (23) soit mobile en va-et-vient,
une première plaque de verrouillage (24) faisant saillie à partir d'une extrémité du premier rail (21) et raccordée à une première oreille mobile,
une seconde plaque de verrouillage (25) faisant saillie à partir d'une extrémité du second rail (22) et raccordée à une seconde oreille mobile,
dans lequel la première oreille mobile comprend une première articulation (11) possédant une première plaque gauche (111) et une première plaque droite (112) qui peut être raccordée à la première plaque de verrouillage (24) par des éléments de verrouillage et qui est raccordée de façon pivotante à la première plaque gauche (111),
dans lequel la première plaque gauche (111) possède un trou allongé (1111) dont l'axe longitudinal est orienté verticalement en fonctionnement et la première plaque droite (112) possède de multiples trous de verrouillage (1121),
dans lequel la seconde oreille mobile comprend une seconde articulation (12) possédant une seconde plaque gauche (121) qui peut être raccordée à la seconde plaque de verrouillage (25) par des éléments de verrouillage et une seconde plaque droite (122) qui est raccordée de façon pivotante à la seconde plaque gauche (121),
dans lequel la seconde plaque gauche (121) possède de multiples trous de verrouillage (1211) et la seconde plaque droite (122) possède un trou allongé (1221) dont l'axe longitudinal est orienté verticalement en fonctionnement,
la première oreille mobile comprenant en outre une première plaque supérieure (113) possédant un trou de verrouillage (1131) et un trou allongé (1132) et une première plaque inférieure (114) possédant un trou de verrouillage (1141) et un trou allongé (1142), dans lequel l'axe longitudinal des trous allongés (1132, 1142) est orienté horizontalement en fonctionnement,
la seconde oreille mobile comprenant en outre une seconde plaque supérieure (123) possédant un trou de verrouillage (1231) et un trou allongé (1232) et une seconde plaque inférieure (124) possédant un trou de verrouillage (1241) et un trou allongé (1242), dans lequel l'axe longitudinal des trous allongés (1232, 1242) est orienté horizontalement en fonctionnement, dans lequel la première plaque gauche (111) est raccordée à la première plaque supérieure (113) et la première plaque inférieure (114),
dans lequel la seconde plaque droite (122) est raccordée à la seconde plaque supérieure (123) et la seconde plaque inférieure (124),
de telle sorte que, lorsque la première plaque droite (112) et la seconde plaque gauche (121) sont respectivement tournées par rapport à la première plaque gauche (111) et la seconde plaque droite (122) et des éléments de verrouillage raccordant la première plaque droite (112) et la seconde plaque gauche (121) aux première et seconde plaques de verrouillage (24, 25) sont enlevés, l'équipement (D) puisse être déplacé vers l'arrière pour que les câbles sur l'avant de l'équipement (D) ne puissent pas gêner le mouvement de l'équipement (D).

2. Dispositif selon la revendication 1, dans lequel la première plaque de verrouillage (24) possède une première portion de raccordement (241) qui possède une première fente (2411), la seconde plaque de verrouillage (25) possède une seconde portion de raccordement (251) qui possède une seconde fente (2511).

3. Dispositif selon la revendication 1, dans lequel le premier rail (21) est raccordé à un premier élément de positionnement (26) et le second rail (22) est raccordé à un second élément de positionnement (27), le premier élément de positionnement (26) est situé de façon correspondante à la première plaque de verrouillage (24) et possède un premier élément de fixation de rail (261) et un premier élément de fixation de râtelier (262), le premier élément de fixation de rail (261) est raccordé au premier élément de fixation de râtelier (262), le second élément de positionnement (27) est situé de façon correspondante à la seconde plaque de verrouillage (25) et possède un second élément de fixation de rail (271) et un second élément de fixation de râtelier (272), le second élément de fixation de rail (271) est raccordé au second élément de fixation de râtelier (272).

4. Dispositif selon la revendication 1, dans lequel le plateau (23) possède au moins un trou débouchant (233).
